# FASCICULE DE BREVET EUROPEEN

(11) **EP 0 678 875 B1**
(45) Date de publication et mention de la délivrance du brevet: **29.09.1999**
(21) Numéro de dépôt: 95400772.0
(22) Date de dépôt: 06.04.1995
(51) Int. Cl.: G11C 16/06

(54) **Procédé d'effacement d'une mémoire et circuits de mise en oeuvre**
Verfahren und Schaltungen zur Löschung eines Speichers
Method and circuits for erasing memory

(30) Priorité: 13.04.1994 FR 9404393
(43) Date de publication de la demande: 25.10.1995
(73) Titulaire: STMicroelectronics S.A., 94250 Gentilly (FR)
(72) Inventeur: Costabello, Claude, Cabinet Ballot-Schmit, F-75116 Paris (FR); Gaultier, Jean-Marie, Cabinet Ballot-Schmit, F-75116 Paris (FR)
(74) Mandataire: Ballot, Paul Denis Jacques

(56) Documents cités:
- EP-A- 0 392 895
- DE-A- 4 119 394
- US-A- 5 270 979
- US-A- 5 274 599
- IEEE JOURNAL OF SOLID-STATE CIRCUITS., vol. 26, no. 11, Novembre 1991 NEW YORK US, pages 1600-1605, NAKAYAMA ET AL 'A 60ns 16Mb flash EEPROM with program and erase sequence controller'

## Description

L'invention concerne les microprocesseurs et, plus particulièrement, un procédé pour effacer la mémoire à semi-conducteurs associée au microprocesseur ainsi que les circuits pour le mettre en oeuvre.

Cette mémoire est du type non volatile, effaçable et programmable électriquement, plus connue sous l'abréviation anglo-saxonne FLASH EEPROM (Electrically Erasable and Programmable Read Only Memory). Une telle mémoire est prévue pour enregistrer, notamment, les instructions des programmes qui sont utilisées par l'unité centrale du microprocesseur pour réaliser la succession des opérations sur des informations ou données à traiter. Du fait de cette utilisation, cette mémoire est adressée essentiellement pour y lire les informations qu'elle contient, l'enregistrement des informations d'effectuant de temps à autre pour y changer les instructions en fonction des programmes à mettre en oeuvre. Cet enregistrement est précédé d'une opération d'effacement de la mémoire pour mettre tous ses points de mémoire dans un état binaire déterminé.

De telles mémoires à semi-conducteurs ont des capacités de plus en plus élevées, pouvant atteindre éventuellement 16 à 64 millions de points ou cellules de mémoire (16 à 64 mégabits), et sont amenées à remplacer les mémoires magnétiques sur disques rotatifs. Elles présentent les avantages principaux suivants :
- temps d'accès court pour la lecture,
- absence de pièces mécaniques en rotation,
- tension d'alimentation faible,
- consommation électrique faible,
- fiabilité accrue,
- fabrication intégrée avec le microprocesseur.

Pour modifier les informations dans ces mémoires à semi-conducteurs, il est nécessaire, comme indiqué ci-dessus, de les effacer pour mettre tous les points ou cellules de mémoire dans un état binaire déterminé : 1 ou 0.

Cette opération d'effacement consiste non seulement à effacer les cellules de mémoire mais aussi à vérifier ensuite si l'effacement a bien conduit à l'état binaire déterminé. Si la vérification indique que certaines cellules de mémoire ne sont pas dans l'état souhaité, une deuxième opération d'effacement est lancée suivie d'une deuxième opération de vérification et ainsi de suite, ce qui peut conduire à une durée d'effacement très longue, de l'ordre de plusieurs secondes car il peut y avoir plusieurs centaines de cycles d'effacement.

En outre, au fur et à mesure des cycles d'effacement successifs, il apparaît un phénomène de déplétion des cellules et leur seuil de conduction diminue.

Le but de la présente invention est de mettre en oeuvre un procédé d'effacement global d'une mémoire à semi-conducteurs qui conduit à une réduction de la durée globale de l'opération d'effacement.

De telles mémoires à semi-conducteurs, par exemple de 64 mégabits peuvent être organisées en 32 secteurs ayant chacun 512.000 cellules de mémoire, ce qui permet d'enregistrer dans chaque secteur 64.000 mots de huit bits chacun.

Dans le procédé d'effacement du type classique, l'effacement s'effectue secteur après secteur et consiste à appliquer une impulsion d'effacement à un secteur sélectionné, à vérifier ensuite l'effacement de chaque cellule du secteur sélectionné et à appliquer une nouvelle impulsion d'effacement au secteur sélectionné dès la détection d'une cellule en défaut. Une telle manière de faire conduit à une durée d'effacement qui peut être longue.

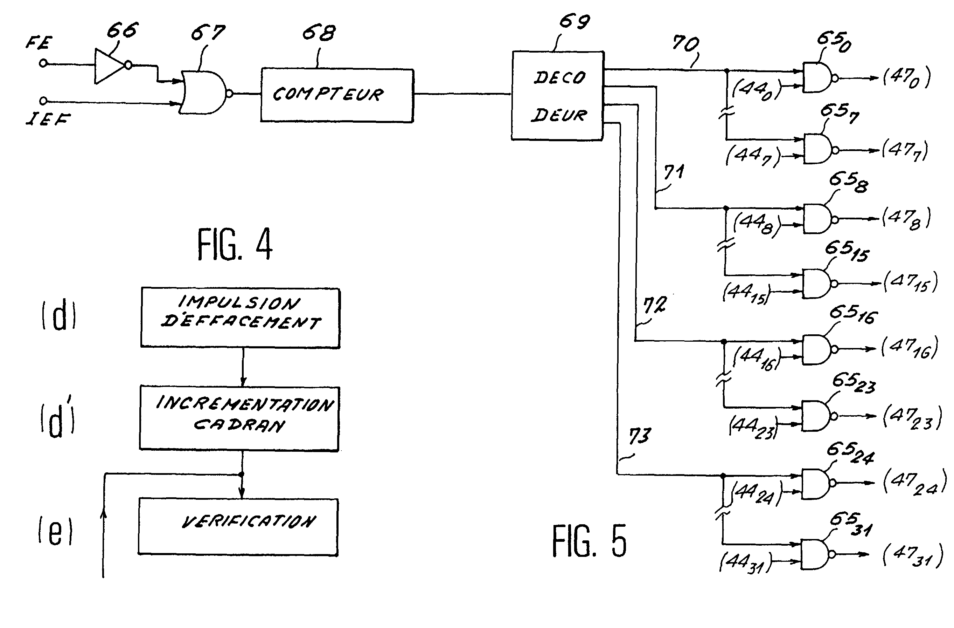

Le document IEEE JOURNAL OF SOLID-STATE CIRCUITS., vol. 26, no. 11, Novembre 1991 NEW YORK US, pages 1600-1605, NAKAYAMA ET AL 'A 60ns 16Mb flash EEPROM with program and erase sequence controller' divulgue une mémoire programmable électriquement qui est divisée en secteurs (voir BLOCK A, ..., dans la fig.5b) et dont l'effacement est obtenu par l'application simultanée d'une impulsion d'effacement audits secteurs, par vérification de l'effacement de chaque secteur et par verrouillage de chaque secteur dont la vérification ne détecte pas de cellule non effacée (voir p.1601, colonne droite, lignes 5-10). De plus, la vérification de l'effacement d'un secteur est arrêtée dès la detection d'une cellule de mémoire non effacée (voir p.1601, colonne gauche, lignes 1-4 de bas). Il n'y est pas suggéré d'assembler les secteurs en groupes et d'appliquer l'impulsion d'effacement seulement aux secteurs formant partie d'un groupe.

Le procédé de l'invention consiste à appliquer simultanément une impulsion d'effacement à tous les secteurs, puis à vérifier ensuite l'effacement secteur après secteur, à verrouiller le secteur dont la vérification a été satisfaisante, à appliquer une nouvelle impulsion d'effacement aux secteurs non verrouillés et à vérifier ensuite ces derniers. Ainsi les cycles d'effacement successifs ne sont effectués que sur les secteurs qui présentent des défauts d'effacement après vérification. De cette manière, la vérification de l'effacement n'a lieu que pour les secteurs dont la vérification précédente avait détecté des défauts d'où un gain de temps appréciable. Par ailleurs, l'effacement proprement dit ne concerne que les secteurs qui présentent des défauts d'effacement, ce qui limite le phénomène de déplétion des cellules.

L'invention a donc pour objet un procédé d'effacement et un circuit de verrouillage de secteur d'une mémoire intégrée non volatile comme indiqués dans les revendications 1 et 2.

D'autres caractéristiques et avantages de la présente invention apparaîtront à la lecture de la description suivante d'un exemple particulier de réalisation, ladite description étant faite en relation avec les dessins joints dans lesquels :

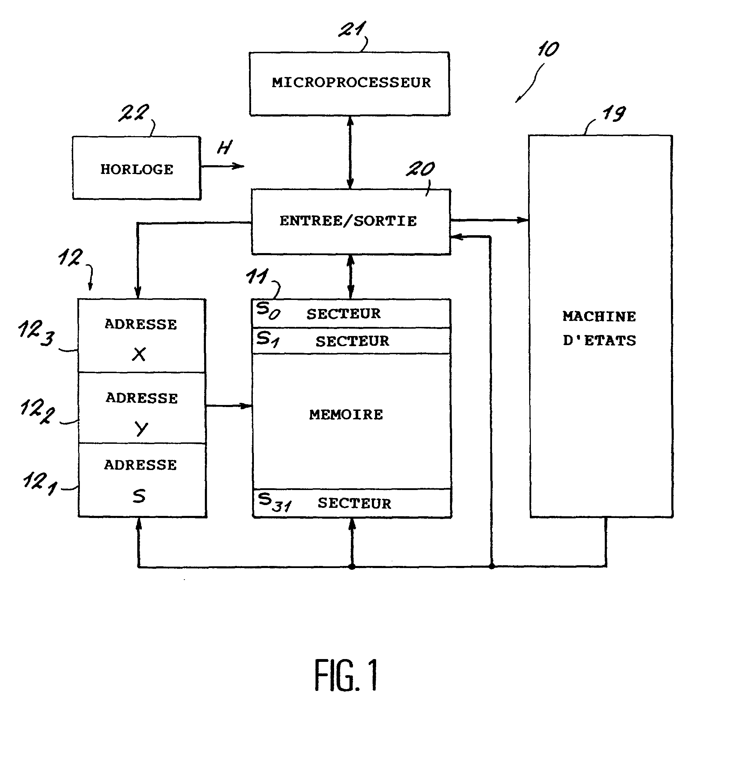

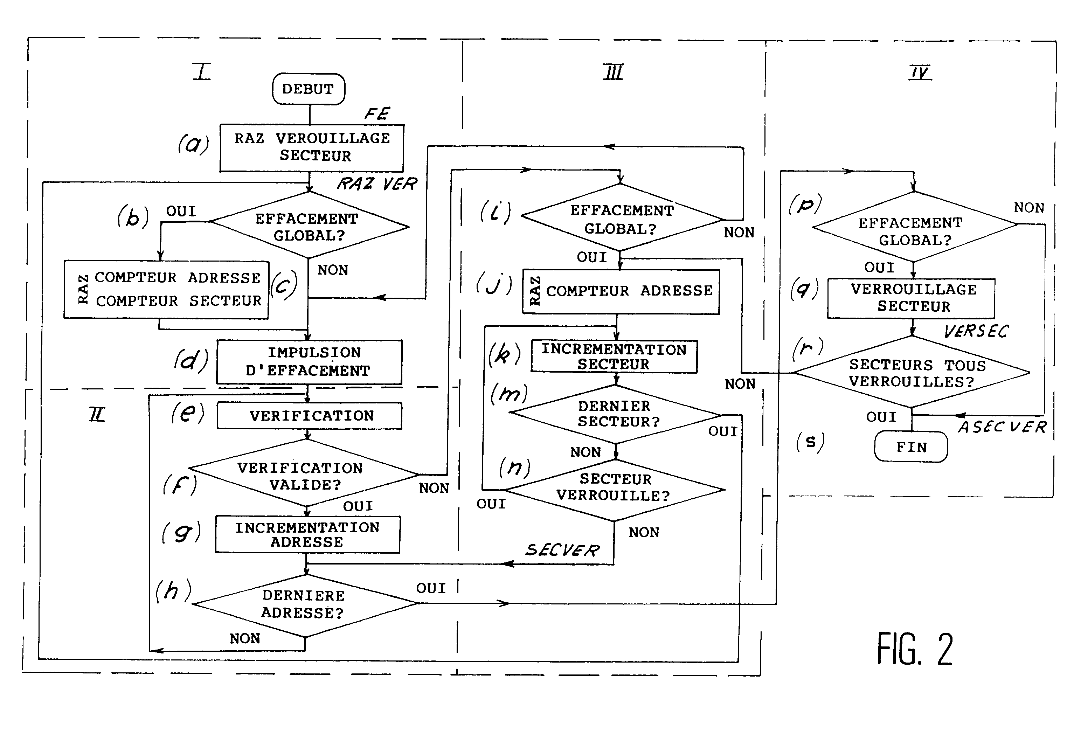

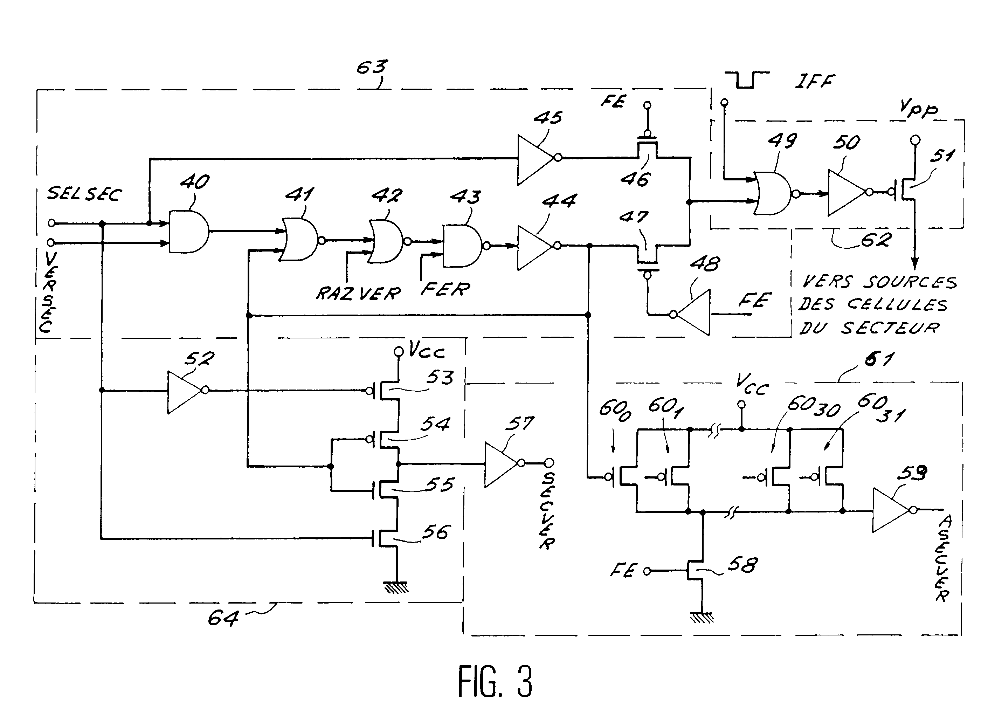

- la figure 1 est un schéma fonctionnel d'une mémoire à semi-conducteurs et de ses circuits associés à laquelle s'applique le procédé d'effacement selon l'invention, la figure 2 est un diagramme montrant les différentes opérations du procédé d'effacement selon l'invention, la figure 3 est un schéma d'un circuit de verrouillage de secteur selon l'invention, la figure 4 est un diagramme montrant différentes étapes d'une variante, et la figure 5 est un schéma du circuit logique qui est ajouté pour mettre en oeuvre cette variante.

Sur la figure 1, l'ensemble mémoire 10 qui est associé à un microprocesseur 21 comprend schématiquement une mémoire 11 proprement dite, des circuits d'adressage 12 de la mémoire 11, un circuit 19 de commande de la mémoire 11, des circuits d'entrée/sortie 20 de la mémoire 11 et un circuit horloge 22 fournissant un signal horloge H, ces différents éléments étant connectés entre eux de manière connue.

A titre indicatif, la mémoire 11 a une capacité de 16 mégabits environ et est divisée en 32 secteurs S₀ à S₃₁ ayant chacun 512.000 cellules de mémoire qui sont groupées en mots de 8 bits, soit 64.000 mots par secteur. Cette mémoire est de préférence du type à circuits intégrés et les cellules sont non volatiles, programmables et effaçables électriquement et plus particulièrement du type "FLASH EEPROM".

Les circuits d'adressage 12 sont organisés pour adresser chacun des 32 secteurs S₀ à S₃₁ par un circuit 12₁ et dans chaque secteur un mot de mémoire par des circuits 12₂ (adresse Y pour les colonnes de bits) et 12₃ (adresse X pour les rangées de mots).

Les circuits entrée/sortie 20 reçoivent des informations ou données du microprocesseur 21 et en fournissent à ce dernier sous la forme de mots ou codes de 8 bits chacun.

Le circuit de commande 19 de la mémoire 11 est essentiellement une machine d'états qui reçoit des codes à 8 bits des circuits d'entrée/sortie 20 et fournit des signaux de commande des circuits d'adressage 12, de la mémoire 11 et des circuits d'entrée/sortie 20.

Les signaux de commande ont pour but de réaliser des opérations déterminées sur la mémoire 11 telles que sa lecture, son enregistrement, son effacement... Dans le cas de l'invention, il est prévu de réaliser l'effacement selon deux modes différents : l'un classique et l'autre, dit effacement global, selon des caractéristiques de l'invention.

La figure 2 donne le diagramme détaillé des différentes étapes du mode ou procédé d'effacement global de la mémoire 11 lorsqu'une instruction d'effacement global FE est reconnue.
(a) Déverrouillage des secteurs pour permettre leur effacement et la vérification de leur effacement, c'est-à-dire remise à zéro (RAZ) du verrouillage des secteurs;
(b) L'instruction est-elle une instruction d'effacement global ?
   - si la réponse est positive, passage à l'étape (c);
   - si la réponse est négative, passage à l'étape (d);
(c) remise à zéro (RAZ) du compteur de secteurs et du compteur d'adresses à l'intérieur de chaque secteur;
(d) effacement des secteurs par application d'une impulsion d'effacement.
(e) vérification de l'effacement cellule par cellule des cellules d'un secteur;
(f) la cellule est-elle effacée ?
   - si la cellule est effacée, passage à l'étape (g);
   - si la cellule n'est pas effacée, passage à l'étape (i);
(g) incrémentation de l'adresse du compteur d'adresses pour vérifier la cellule suivante;
(h) l'adresse incrémentée est-elle supérieure à la dernière adresse du secteur ?
   - si la réponse est négative, retour à l'étape (e) de vérification de la cellule correspondant à l'adresse incrémentée;
   - si la réponse est positive, passage à l'étape (p);
(i)-dans le cas où la cellule en vérification n'est pas effacée, l'instruction est-elle une instruction d'effacement global;
   - si la réponse est négative, retour à l'étape (d);
   - si la réponse est positive, passage à l'étape (j);
(j) remise à zéro (RAZ) du compteur d'adresse de secteur;
(k) incrémentation d'une unité du compteur de secteur;
(m) l'adresse incrémentée du compteur de secteur est-elle supérieure à la dernière adresse de secteur ?
   - si la réponse est négative, passage à l'étape (n) de vérification de verrouillage du secteur;
   - si la réponse est positive, retour à l'étape (b);
(n) le secteur est-il verrouillé ?
   - si le secteur n'est pas verrouillé, retour à l'étape (h);
   - si le secteur est verrouillé, retour à l'étape (k) d'incrémentation du compteur de secteur;
(p) dans le cas où l'adresse du compteur d'adresse est la dernière adresse du secteur, l'instruction est-elle une instruction d'effacement global ?
   - si la réponse est positive, passage à l'étape (q);
   - si la réponse est négative, passage à l'étape "FIN";
(q) verrouillage du secteur vérifié sans faute dans le cas d'un effacement global;
(r) les secteurs sont-ils tous verrouillés ?
   - si la réponse est négative, retour à l'étape (j) de remise à zéro du compteur d'adresse dans le secteur suivie de l'étape (k) d'incrémentation du compteur secteur de manière à vérifier le secteur suivant;
   - si la réponse est positive, passage à l'étape (s) indiquant la "FIN" de l'effacement;

Les différentes étapes du procédé qui viennent d'être décrites en relation avec le diagramme de la figure 2 montrent que ce procédé réalise les deux modes d'effacement selon le signal de commande qui est appliqué.

Ainsi, lorsqu'une cellule n'est pas effacée dans un secteur (étape (f)) et qu'il s'agit du mode classique (étape (i)), on effectue un nouvel effacement en envoyant une impulsion d'effacement. Par ailleurs, lorsque toutes les cellules d'un secteur ont été vérifiées (étape (h)) et qu'il s'agit du mode classique (étape (p)), ceci est interprété comme la fin de l'effacement.

Le diagramme détaillé de la figure 2 fait apparaître quatre phases :
- une première phase I qui consiste à appliquer une impulsion d'effacement aux secteurs,
- une deuxième phase II qui consiste à vérifier l'effacement de chaque cellule de mémoire dans un secteur,
- une troisième phase III qui consiste à passer d'un secteur à l'autre pour la vérification, et
- une quatrième phase IV qui consiste à verrouiller le secteur sans défaut d'effacement.

De manière plus synthétique, on peut définir le procédé selon l'invention par les étapes suivantes :
(A) effacement proprement dit de la mémoire par l'application simultanée d'une impulsion à tous les secteurs S₀ à S₃₁;
(B) vérification, secteur après secteur, de l'effacement de chaque cellule de la mémoire;
(C) verrouillage de chaque secteur dont la vérification ne détecte pas de cellule non effacée,
(D) vérification du verrouillage de tous les secteurs
   - si réponse positive, fin de l'opération d'effacement,
   - si réponse négative, passage à l'étape suivante,
(E) application d'une impulsion d'effacement aux secteurs non verrouillés,
(F) vérification, secteur après secteur, des secteurs non verrouillés,
(G) retour à l'étape (C).

Afin de réaliser le verrouillage des secteurs au fur et à mesure de leur vérification, il est prévu un circuit de verrouillage par secteur tel que celui de la figure 3 de manière à empêcher l'application de l'impulsion d'effacement aux secteurs verrouillés.

Ce circuit logique comprend un circuit ET 40 à deux entrées, l'une à laquelle est appliquée le signal de sélection du secteur SELSEC (figure 2) concerné, par exemple le secteur S0 et l'autre à laquelle est appliquée le signal de verrouillage de secteur. La sortie du circuit ET 40 est connectée à une des deux entrées d'un premier circuit NON-OU 41 dont l'autre entrée est connectée à la sortie d'un circuit inverseur 44.

La sortie de ce premier circuit NON-OU 41 est connectée à une des deux entrées d'un deuxième circuit NON-OU 42 dont l'autre entrée reçoit un signal de remise à zéro du verrouillage des secteurs RAZVER (figure 2).

La sortie de ce deuxième circuit NON-OU 42 est connectée à une des deux entrées d'un circuit NON-ET 43 dont l'autre entrée reçoit le signal d'effacement global FE.

La sortie du circuit NON-ET 43 est connectée à l'entrée du circuit inverseur 44 dont la sortie est connectée à l'entrée du premier circuit NON-OU 41, comme décrit ci-dessus.

La sortie du circuit inverseur 44 est aussi connectée, d'une part, au drain d'un transistor MOSFET 47 de type P et, d'autre part, à la grille d'un transistor MOSFET 60₀ de type p qui fait partie d'un circuit NON-ET 60.

Ce circuit NON-ET 60 comprend autant de transistors MOSFET 60₀, 60₁ ...60₃₁ que de secteurs, la grille de chaque transistor étant connectée à la sortie du circuit inverseur 44 du circuit de verrouillage du secteur associé.

La source du transistor 47 est connectée à une entrée d'un troisième circuit NON-OU 49 qui comporte une autre entrée recevant l'impulsion d'effacement IEF. La source du transistor 47 est également connectée à la source d'un transistor MOSFET 46 de type P.

La grille du transistor 46 reçoit le signal d'effacement global FE tandis que le drain est connecté à la sortie d'un circuit inverseur 45 dont l'entrée reçoit le signal de sélection de secteur qui est aussi appliqué au circuit ET 40.

La sortie du circuit NON-OU 49 est connectée à un circuit inverseur 50 dont la sortie est connectée à la grille d'un transistor MOSFET 51 de type P. Le drain du transistor 51 est connecté à la tension d'alimentation Vₚₚ tandis que la source est connectée aux sources des transistors constituant chaque cellule de la mémoire.

Le signal de sélection de secteur SELSEC est appliqué directement à la grille d'un transistor MOSFET 56 de type N et, par l'intermédiaire d'un circuit inverseur 52, à la grille d'un transistor MOSFET 53 de type P. Le drain du transistor 53 est connecté à la tension d'alimentation V_{cc} tandis que sa source est connectée au drain d'un transistor MOSFET 54 du type P.

Par ailleurs, la source du transistor 56 est connectée au potentiel de la masse Vss tandis que son drain est connecté à la source d'un transistor MOSFET 55 de type N dont le drain est connecté à la source du transistor 54.

Les grilles des transistors 54 et 55 sont connectées entre elles et à la sortie du circuit inverseur 44. Le point commun source/drain des transistors 54 et 55 est connecté à l'entrée d'un circuit inverseur 57 qui est commun à tous les secteurs comme le circuit NON-ET 60.

La sortie du circuit inverseur 57 fournit le signal SECVER indiquant que le secteur est verrouillé.

Sur la figure 3, les NON-ET 60₀ à 60₃₁ et le circuit inverseur 57 qui sont communs à tous les secteurs ont été regroupés sous la référence 61. Le circuit de la figure 3 peut être divisé fonctionnellement en plusieurs éléments :
- un circuit de porte 62 comprenant les éléments 49 à 51,
- un circuit de verrouillage/déverrouillage 63 comprenant les éléments 40 à 48,
- un circuit 64 de détection de verrouillage du secteur comprenant les éléments 52 à 57, et
- un circuit 61 de détection de verrouillage de tous les secteurs comprenant les éléments 58 à 60.

Les circuits 61, 63 et 64 réalisent un circuit logique de commande du circuit de porte 62.

Le circuit de verrouillage de secteur tel que décrit en relation avec la figure 3 fonctionne de la manière suivante. Lors de la sélection d'un secteur (signal SELSEC) en mode classique, le transistor 46 est conducteur car le signal FE d'effacement global est absent. Le circuit NON-OU 49, qui reçoit l'impulsion d'effacement IEF, fournit un signal de conduction du transistor 51 par l'intermédiaire de l'inverseur 50.

L'impulsion d'effacement n'est donc appliquée, en mode classique, qu'aux cellules du secteur sélectionné par SELSEC.

En mode d'effacement global, le transistor 47 peut devenir conducteur car le signal FE d'effacement global est appliqué au circuit inverseur 48. Comme précédemment, le transistor 51 devient conducteur et applique l'impulsion d'effacement IEF à toutes les cellules du secteur sélectionné.

Cependant, cette impulsion d'effacement IEF ne doit être appliquée qu'aux secteurs non verrouillés, ce qui signifie que le transistor 47 ne doit pas devenir conducteur lorsque le secteur est verrouillé. Ceci est obtenu par le signal VERSEC (étape (q)) pour le secteur sélectionné (signal SELSEC) : le circuit ET 40 fournit alors un niveau 1 de sorte que la sortie du circuit NON-OU 41 est au niveau 0; il en est de même de la sortie du circuit NON-OU 42 qui est donc au niveau 0. La sortie du circuit ET 43 est au niveau 0, ce qui entraîne un niveau 1 sur la sortie du circuit inverseur 44, d'où un blocage du transistor 47.

Au début de l'effacement global, tous les secteurs sont verrouillés mais aucun secteur n'est sélectionné de sorte que la sortie du circuit ET 40 est au niveau 0. La sortie du circuit NON-OU 41 est aussi au niveau 0 car la deuxième entrée est au niveau 1 correspondant au verrouillage. Lorsque le signal RAZVER (étape (a)) passe au niveau 1, la sortie du circuit NON-OU 42 passe au niveau 0. Comme le signal FE est présent, la sortie du circuit NON-ET 43 passe au niveau 1 tandis que la sortie du circuit inverseur 44 passe au niveau 0.

Le niveau 0 du circuit inverseur 44 est appliqué à l'entrée du circuit NON-OU 41 tandis que le niveau 0 est appliqué sur l'autre entrée. La sortie du circuit NON-OU 41 passe à l'état 1.

Comme le signal RAZVER est revenu au niveau 0, la sortie du circuit NON-OU 42 reste au niveau 0.

La sortie du circuit NON-ET 43 reste au niveau 1 et la sortie du circuit inverseur 44 reste au niveau 0 correspondant au déverrouillage.

Lorsque toutes les cellules d'un secteur sélectionné (SELSEC) ont été vérifiées comme étant effacées, le signal VERSEC (étape(q)) apparaît de sorte que le circuit ET 40 est ouvert et passe au niveau 1. La sortie du circuit inverseur 44 étant au niveau 0 (secteur non verrouillé), la sortie du circuit NON-OU 41 passe au niveau 0. Comme le signal RAZVER est au niveau 0, la sortie du circuit NON-ET 43 passe alors au niveau 0 tandis que la sortie du circuit inverseur 44 passe au niveau 1.

Avant la fin de la vérification du secteur, le niveau 0 du circuit inverseur 44 est appliqué aux grilles des transistors 54 et 55 de sorte que seul le transistor 54 peut être conducteur. Par ailleurs, comme le secteur est sélectionné, un niveau 0 est appliqué à la grille du transistor 53 qui le rend conducteur au travers du transistor 54. L'entrée du circuit inverseur 57 est alors au niveau 1 et sa sortie au niveau 0, ce qui signifie que le secteur n'est pas verrouillé.

A la fin de la vérification, par suite de l'apparition du signal VERSEC, la sortie de l'inverseur 44 passe au niveau 1 qui est appliqué au transistor 54 pour le bloquer. Par contre, les transistors 55 et 56 deviennent conducteurs et appliquent le niveau 0 à l'entrée du circuit inverseur 57 dont la sortie passe au niveau 1.

Lorsqu'au moins un secteur n'est pas verrouillé, un niveau 0 est appliqué à la grille du transistor 60 qui correspond au secteur de sorte que ce transistor est conducteur au travers du transistor 58 qui reçoit le signal FE. Un niveau 1 est donc appliqué à l'entrée du circuit inverseur 59 et sa sortie est alors au niveau 0.

Par contre, lorsque tous les secteurs sont verrouillés, aucun transistor 60₀ à 60₃₁ n'est conducteur et le niveau 0 est appliqué à l'entrée du circuit inverseur 59 dont la sortie passe alors au niveau 1 pour le signal ASECVER.

L'invention a été décrite dans le cas d'une impulsion d'effacement appliquée simultanément à tous les secteurs de la mémoire. Une telle manière de faire implique un courant d'effacement qui est de valeur élevée. Aussi, pour limiter ce courant d'effacement, l'invention propose dans une variante de n'appliquer l'impulsion d'effacement qu'à un groupe de secteurs, par exemple à huit d'entre eux, ce qui revient dans cet exemple à diviser les trente-deux secteurs en quatre groupes ou cadrans de huit secteurs chacun, par exemple un premier cadran pour les secteurs S₀ à S₇, un deuxième cadran pour les secteurs S₈ à S₁₅, un troisième cadran pour les secteurs S₁₆ à S₂₃ et un quatrième cadran pour les secteurs S₂₄ à S₃₁.

Pour réaliser cette variante, le procédé qui a été décrit en relation avec la figure 2 doit inclure une étape supplémentaire d'incrémentation d'un compteur de cadrans entre les étapes (d) et (e) (figure 4) tandis que le circuit de verrouillage de la figure 3 doit comprendre un circuit NON-ET 65 (figure 5) dont l'une des deux entrées est connectée à la sortie du circuit inverseur 44 tandis que l'autre entrée est connectée à la sortie du compteur de cadrans qui sera décrit en relation avec le schéma de la figure 5.

Ainsi, sur la figure 4, une étape (d') d'incrémentation de cadran est insérée entre l'étape (d) d'application de l'impulsion d'effacement et l'étape (e) de vérification de l'effacement de tous les secteurs.

Sur la figure 5, le circuit NON-ET 65, qui est ajouté dans chaque circuit de verrouillage (circuits NON-ET 65₀ à 65₃₁) est commandé par les signaux de sortie d'un décodeur 69 des quatre états du compteur binaire 68 des cadrans, le compteur et le décodeur réalisant un circuit de multiplexage.

Ces signaux de sortie du décodeur 69 sont appliqués par l'intermédiaire des conducteurs 70, 71, 72 et 73 qui sont connectés respectivement aux circuits NON-ET 65₀ à 65₇ pour les secteurs du premier cadran, 65₈ à 65₁₅ pour les secteurs du deuxième cadran, 65₁₆ à 65₂₃ pour les secteurs du troisième cadran et 65₂₄ à 65₃₁ pour les secteurs du quatrième cadran. L'entrée du compteur binaire à deux chiffres 68 est connectée à la sortie d'un circuit NON-ET 67 à deux entrées dont une entrée reçoit l'impulsion d'avancement IEF tandis que l'autre reçoit le signal FE d'effacement global par l'intermédiaire d'un circuit inverseur 66.

Sur la figure 5, les indices 0 à 31 indiquent le rang du secteur tandis que les références auxquelles ils sont associés indiquent celles des circuits logiques de la figure 3.

Le fonctionnement de cette variante de l'invention est alors le suivant. L'impulsion d'effacement incrémente le compteur de cadrans 68 d'une unité, ce qui permet de sélectionner les secteurs du cadran suivant, par exemple le deuxième cadran, dont les secteurs recevront l'impulsion d'effacement. Il est ensuite procédé à l'étape (e) de vérification de l'effacement comme dans le procédé d'effacement global. Si, après vérification de tous les secteurs de la mémoire, l'un d'entre eux n'est pas effacé et n'est donc pas verrouillé, une nouvelle impulsion d'effacement est élaborée, ce qui incrémente d'une unité le compteur 68 de sorte que l'impulsion d'effacement est appliquée à tous les secteurs du cadran suivant, c'est-à-dire le troisième cadran. Puis une nouvelle étape (e) de vérification d'effacement est mise en oeuvre pour tous les secteurs et ainsi de suite jusqu'au verrouillage de tous les secteurs.

En résumé, dans cette variante, l'impulsion d'effacement n'est appliquée qu'à un seul groupe ou cadran de secteurs mais la vérification de l'effacement est réalisée sur tous les secteurs non verrouillés.

Dans le procédé général de l'invention, cette variante consiste à modifier le libellé des étapes (A) et (E) pour indiquer que l'impulsion d'effacement est appliquée aux secteurs d'un groupe ou cadran.

Plus généralement, les groupes seront au nombre de m et comporteront chacun n secteurs tels que m.n = N.

## Revendications

1. Procédé d'effacement d'une mémoire intégrée (11) non volatile, effaçable et programmable électriquement, qui est divisée en N secteurs (S0...S31) sélectionnés séparément par des circuits d'adressage (12₃), les N secteurs pouvant être assemblés en m groupes de n secteurs chacun, les cellules de chaque secteur étant sélectionnées par des circuits d'adressage (12₁, 12₂) par rangées et colonnes, qui comprend les étapes suivantes :
(A) effacement de la mémoire par l'application simultanée d'une impulsion à au moins tous les secteurs d'un groupe;
(B) vérification, secteur après secteur, de l'effacement de chaque cellule de la mémoire, la vérification de l'effacement d'un secteur étant arrêtée dès la détection d'une cellule de mémoire non effacée;
(C) verrouillage de chaque secteur dont la vérification ne détecte pas de cellule non effacée;
(D) vérification du verrouillage de tous les secteurs
- si réponse positive, fin de l'opération d'effacement,
- si réponse négative, passage à l'étape suivante,
(E) application d'une impulsion d'effacement aux secteurs non verrouillés du groupe suivant;
(F) vérification, secteur après secteur, des secteurs non verrouillés;
(G) retour à l'étape (C).

2. Circuit de verrouillage de secteur dans une mémoire intégrée non volatile, effaçable et programmable électriquement qui est divisée en N secteurs (S0 à S31) sélectionnés séparément par des circuits d'adressage, les cellules de chaque secteur étant sélectionnées par des circuits d'adressage par rangées et colonnes, l'effacement de la mémoire étant obtenue par l'application simultanée d'une impulsion d'effacement aux secteurs, par vérification de l'effacement de chaque secteur et par verrouillage de chaque secteur dont la vérification ne détecte pas de cellule non effacé, le circuit de verrouillage comprenant
- un circuit de porte (62) sur le circuit d'alimentation de l'effacement d'un secteur auquel est appliquée l'impulsion d'effacement, et
- un circuit logique (61, 63, 64) pour commander l'ouverture ou la fermeture du circuit de porte de manière à appliquer l'impulsion d'effacement au secteur que si ledit secteur comporte une cellule non effacée,
caractérisé en ce que les N secteurs sont assemblés en m groupes de n secteurs chacun, et en ce que le circuit logique commande l'ouverture ou la fermeture dudit circuit de porte seulement aux secteurs formant partie d'un groupe.

3. Circuit de verrouillage selon la revendication 2, caractérisé en ce que le circuit logique de commande comprend :
- un circuit de verrouillage/déverrouillage (63) pour ouvrir le circuit de porte (62) au début de l'opération d'effacement,
- un circuit (64) de détection de verrouillage du secteur, et
- un circuit (61) de détection de verrouillage de tous les secteurs.

4. Circuit de verrouillage selon la revendication 3, caractérisé en ce que le circuit de verrouillage/ déverrouillage (63) comprend, dans le cas de l'application d'une impulsion d'effacement aux secteurs d'un groupe, un compteur de groupes (68) à m états dont l'avance est commandée par les impulsions d'effacement et un circuit de multiplexage (65, 69 à 73) commandé par les signaux d'état dudit compteur pour sélectionner le groupe dont les secteurs recevront l'impulsion d'effacement.

## Patentansprüche

1. Verfahren zur Löschung eines integrierten nicht flüchtigen, elektrisch lösch- und programmierbaren Speichers (11), der in N Sektoren (S₀ ... S₃₁) unterteilt ist, die getrennt durch Adressierungsschaltungen (12₃) ausgewählt werden, wobei die N Sektoren aus m Gruppen von jeweils n Sektoren zusammengesetzt sein können, wobei die Zellen jedes Sektors durch Adressierungsschaltungen (12₁, 12₂) über Zeilen und Spalten ausgewählt werden, mit folgenden Schritten:
(A) Löschen des Speichers durch gleichzeitiges Anlegen eines Impulses an mindestens alle Sektoren einer Gruppe;
(B) Überprüfen der Löschung jeder Speicherzelle Sektor für Sektor, wobei die Überprüfung der Löschung eines Sektors angehalten wird, sobald eine nicht gelöschte Speicherzelle erkannt wird;
(C) Sperren jedes Sektors, bei dem die Überprüfung keine nicht gelöschte Zelle erkennt;
(D) Überprüfen der Sperrung aller Sektoren,
- bei positiver Antwort, Ende der Löschoperation,
- bei negativer Antwort, Sprung zu nächstem Schritt,
(E) Anlegen eines Löschimpulses an die nicht gesperrten Sektoren der nachfolgenden Gruppe;
(F) Überprüfen der nicht gesperrten Sektoren Sektor für Sektor;
(G) Rücksprung zu Schritt (C).

2. Schaltung zur Sperrung von Sektoren in einem integrierten, nicht flüchtigen, elektrisch lösch- und programmierbaren Speicher, der in N Sektoren (S₀ bis S₃₁) unterteilt ist, die getrennt durch Adressierungsschaltungen ausgewählt werden, wobei die Zellen jedes Sektors durch Adressierungsschaltungen über Zeilen und Spalten ausgewählt werden, wobei die Löschung des Speichers durch das gleichzeitige Anlegen eines Löschimpulses an die Sektoren, durch Überprüfen der Löschung jedes Sektors und durch Sperren jedes Sektors, dessen Überprüfung keine nicht gelöschte Zelle erkennt, erreicht wird, mit folgenden Merkmalen:
- eine Torschaltung (62) an der Versorgungsschaltung zur Löschung eines Sektors, an den der Löschimpuls angelegt wird und
- eine Logikschaltung (61, 63, 64), um das Öffnen oder Sperren der Torschaltung zu steuern, so daß der Löschimpuls nur dann an den Sektor angelegt wird, wenn der Sektor eine nicht gelöschte Zelle enthält, **dadurch gekennzeichnet, daß**
die N Sektoren aus m Gruppen mit jeweils n Sektoren zusammengesetzt sind und daß die Logikschaltung das Öffnen oder Sperren der Torschaltung nur bei den Sektoren steuert, die Teil einer Gruppe bilden.

3. Schaltung zur Sperrung nach Anspruch 2, **dadurch gekennzeichnet, daß** die Logik-Steuerschaltung folgende Merkmale aufweist:
- eine Schaltung zur Sperrung/Entsperrung (63) zum Öffnen der Torschaltung (62) zu Beginn der Löschoperation,
- eine Schaltung (64) zur Erkennung der Sperrung des Sektors und
- eine Schaltung (61) zur Erkennung der Sperrung von allen Sektoren.

4. Schaltung zur Sperrung nach Anspruch 3, **dadurch gekennzeichnet, daß**
die Schaltung zur Sperrung/Entsperrung (63) im Fall des Anlegens eines Löschimpulses an die Sektoren einer Gruppe einen Gruppenzähler (68) für m Zustände auweist, dessen Vorrücken durch die Löschimpulse gesteuert wird, und eine Multiplexer-Schaltung (65, 69 bis 73) aufweist, die durch die Zustandssignale des Zählers gesteuert wird, um die Gruppe auszuwählen, deren Sektoren den Löschimpuls erhalten.

## Claims

1. A method of erasing an integrated electrically erasable programmable read-only memory (11) which is divided into N sectors (S0...S31) separately selected by addressing circuits (12₃), the N sectors being assembled in m groups of n sectors each, the cells of each sector being selected by circuits for addressing (12₁, 12₂) by rows and columns, which comprises the following steps:
(A) erasing the memory by simultaneously applying a pulse to at least all the sectors of a group;
(B) verifying, sector after sector, that each cell of the memory has been erased, verification that a sector has been erased being halted as soon as a non-erased memory cell is detected;
(C) locking each sector in which the verification does not detect a non-erased cell;
(D) verification that all the sectors have been locked
- if the response is positive, end of the erase operation,
- if the response is negative, move on to the next step,
(E) applying an erase pulse to the non-locked sectors of the following group;
(F) verification, sector after sector, of the non-locked sectors;
(G) return to step (C).

2. A sector-locking circuit in an integrated electrically erasable programmable read-only memory which is divided into N sectors (S0 to S31) which are separately selected by addressing circuits, the cells of each sector being selected by circuits for addressing by rows and columns, erasure of the memory being obtained by simultaneously applying an erase pulse to the sectors by verifying that each sector has been erased and by locking each sector in which the verification does not detect a non-erased cell, the locking circuit comprising
- a gate circuit (62) on the erase supply circuit of a sector to which the erase pulse is applied and
- a logic circuit (61, 63, 64) to control the opening or closing of the gate in order to apply the erase pulse to the sector if said sector contains a non-erased cell,
characterised in that the N sectors are assembled in m groups of n sectors each and in that the logic circuit controls the opening or closing of said gate circuit only at sectors forming part of a group.

3. A locking circuit as claimed in claim 2, characterised in that the control logic circuit comprises:
- a locking/unlocking circuit (63) for opening the gate circuit (62) at the start of the erase operation,
- a lock detection circuit (64) for the sector and
- a lock detection circuit (61) for all the sectors.

4. A locking circuit as claimed in claim 3, characterised in that if an erase pulse is applied to the sectors of a group, the locking/unlocking circuit (63) has a group counter (68) with m states, the advance of which is controlled by the erase pulses, and a multiplexing circuit (65, 69 to 73) controlled by the state signals of said counter in order to select the group whose sectors will receive the erase pulse.
